(19) **Europäisches Patentamt**
**European Patent Office**
**Office européen des brevets**

(11) **EP 2 395 662 B1**

(12) **FASCICULE DE BREVET EUROPEEN**

(45) Date de publication et mention
de la délivrance du brevet:
**16.04.2014 Bulletin 2014/16**

(21) Numéro de dépôt: **11165632.8**

(22) Date de dépôt: **11.05.2011**

(51) Int Cl.:
*G04F 5/06* (2006.01)   *H03H 3/02* (2006.01)
*H03H 3/04* (2006.01)   *H03H 9/24* (2006.01)
*H03H 9/02* (2006.01)   *H03H 9/215* (2006.01)

(54) **Résonateur thermocompensé aux premier et second ordres**

Resonator mit Temperaturkompensation erster und zweiter Ordnung

Resonator with temperature compensation of first and second order

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **10.06.2010 EP 10165563**

(43) Date de publication de la demande:
**14.12.2011 Bulletin 2011/50**

(73) Titulaire: **The Swatch Group Research and
Development Ltd.
2074 Marin (CH)**

(72) Inventeurs:
• **Hessler, Thierry
2024 St-Aubin (CH)**
• **Dalla Piazza, Silvio
2610 St-Imier (CH)**

(74) Mandataire: **Couillard, Yann Luc Raymond et al
ICB
Ingénieurs Conseils en Brevets SA
Faubourg de l'Hôpital 3
2001 Neuchâtel (CH)**

(56) Documents cités:
**EP-A1- 2 284 629     WO-A1-2009/068091
US-A1- 2005 184 628**

• **MELAMUD R ET AL: "Temperature-Insensitive
Composite Micromechanical Resonators",
JOURNAL OF MICROELECTROMECHANICAL
SYSTEMS, IEEE SERVICE CENTER,
PISCATAWAY, NJ, US, vol. 18, no. 6, 1 décembre
2009 (2009-12-01), pages 1409-1419,
XP011283695, ISSN: 1057-7157, DOI: DOI:
10.1109/JMEMS.2009.2030074**

**Description**

Domaine de l'invention

L'invention se rapporte à un résonateur thermocompensé du type balancier-spiral, diapason ou plus généralement MEMS permettant de fabriquer une base de temps ou de fréquence dont les coefficients thermiques sont sensiblement nuls aux premier et deuxième ordres.

Arrière plan de l'invention

Le document EP 1 422 436 divulgue un spiral formé en silicium et recouvert de dioxyde de silicium afin de rendre le coefficient thermique sensiblement nul autour des températures de procédure COSC, c'est-à-dire entre +8 et +38 °C. De même, le document WO 2008-043727 divulgue un résonateur MEMS qui possède des qualités similaires de faible dérive de son module d'Young dans la même plage de température (voir aussi US 2005/184628).

Cependant la dérive de la fréquence même uniquement au deuxième ordre des divulgations ci-dessus peut nécessiter des corrections complexes selon les applications. Par exemple, pour que des montres électroniques à quartz puissent être certifiées COSC, une correction électronique basée sur une mesure de la température doit être effectuée.

Résumé de l'invention

Le but de la présente invention est de pallier tout ou partie les inconvénients cités précédemment en proposant un résonateur en quartz compensé thermiquement aux premier et deuxième ordres.

A cet effet, l'invention se rapporte à un résonateur thermocompensé comportant un corps utilisé en déformation, l'âme du corps étant formé à partir d'une plaque formée selon un angle ($\theta$) de coupe dans un cristal de quartz déterminant des coefficients thermiques aux premier et deuxième ordres caractérisé en ce que le corps comporte un revêtement déposé au moins partiellement contre l'âme et ayant des variations du module d'Young en fonction de la température aux premier et deuxième ordres de signes opposés respectivement auxdits premier et deuxième ordres des coefficients thermiques dudit résonateur afin de rendre ces derniers sensiblement nuls.

Avantageusement selon l'invention, le corps du résonateur utilisé en déformation comporte un seul revêtement pour compenser deux ordres. Ainsi, suivant les grandeurs et les signes de chaque ordre du matériau de revêtement, le calcul de l'angle de coupe dans le monocristal de quartz et de l'épaisseur du revêtement est effectué afin de compenser les deux premiers ordres.

Conformément à d'autres caractéristiques avantageuses de l'invention :

- le corps comporte une section sensiblement en forme d'un quadrilatère dont les faces sont identiques deux à deux ;
- le corps comporte une section sensiblement en forme d'un quadrilatère dont les faces sont entièrement revêtues ;
- l'angle de coupe de la plaque est choisi afin que lesdits coefficients thermiques aux premier et deuxième ordres soient négatifs et le revêtement comporte des variations du module d'Young aux premier et deuxième ordres qui sont positifs ;
- le revêtement comporte du dioxyde de germanium ;
- l'angle de coupe de la plaque est choisi afin que lesdits coefficients thermiques aux premier et deuxième ordres soient respectivement positif et négatif et le revêtement comporte des variations du module d'Young aux premier et deuxième ordres qui sont respectivement négatif et positif ;
- le revêtement comporte du diamant synthétique ;
- le corps est un barreau enroulé sur lui-même en formant un spiral et est couplé avec une inertie ;
- le corps comporte au moins deux bras montés symétriquement afin de former un diapason ;
- le diapason est du type inversé et/ou du type rainuré et/ou du type conique et/ou du type palmé ;
- le corps est un MEMS.

Enfin, l'invention se rapporte également à une base de temps ou de fréquence, comme par exemple une pièce d'horlogerie, caractérisée en ce qu'elle comporte au moins un résonateur conforme à l'une des variantes précédentes.

Description sommaire des dessins

D'autres particularités et avantages ressortiront clairement de la description qui en est faite ci-après, à titre indicatif et nullement limitatif, en référence aux dessins annexés, dans lesquels :

- les figures 1 à 4 sont des représentations générales en perspective de plusieurs types de résonateur du type diapason ;

- les figures 5A, 5B, 6A et 6B sont des alternatives de sections des résonateurs des figures 1 à 4 ;
- la figure 7 est une représentation générale en perspective d'une partie d'un résonateur balancier - spiral ;
- la figure 8 est une section représentative du ressort-spiral de la figure 7;
- la figure 9 est un graphique représentant les coefficients thermiques du premier et deuxième ordre d'un diapason suivant son angle de coupe dans un monocristal de quartz ;
- la figure 10 est un graphique représentant la variation des premier et deuxième ordres du coefficient thermique d'un diapason de quartz coupé selon un angle égal à -8,4° par rapport à l'axe Z en fonction de l'épaisseur d'une couche de dioxyde de germanium ;
- les figures 11 et 12 sont des représentations schématiques d'un angle de coupe par rapport aux axes cristallographiques d'un cristal de quartz.

Description détaillée des modes de réalisation préférés

Comme expliqué ci-dessus, l'invention se rapporte à un résonateur en quartz qui peut être du type balancier-spiral, diapason ou plus généralement un résonateur du type MEMS (abréviation provenant des termes anglais « Micro Electro-Mechanical System »). Afin d'apporter une explication plus simple de l'invention, seules les applications à un balancier-spiral et à des diapasons sont présentées ci-dessous. Cependant, d'autres applications de résonateur seront réalisables pour un homme du métier sans difficultés excessives à partir de l'enseignement ci-dessous.

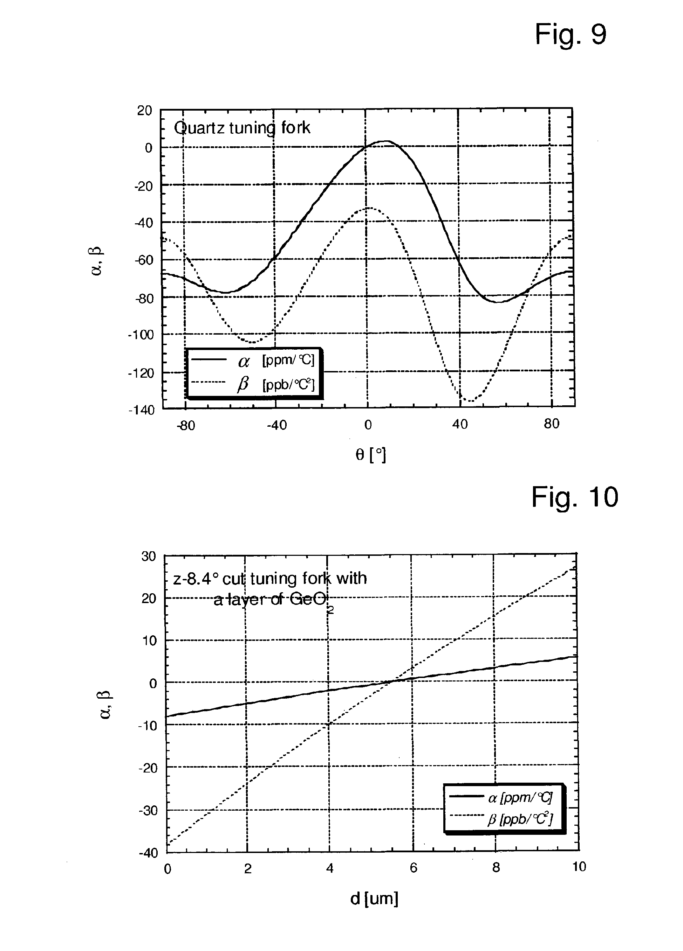

Dans le graphique à la figure 9, on peut voir la caractérisation de la dérive des coefficients thermiques au premier et deuxième ordres pour des résonateurs du type diapason actuels en fonction de l'angle de coupe selon l'axe z d'un cristal de quartz.

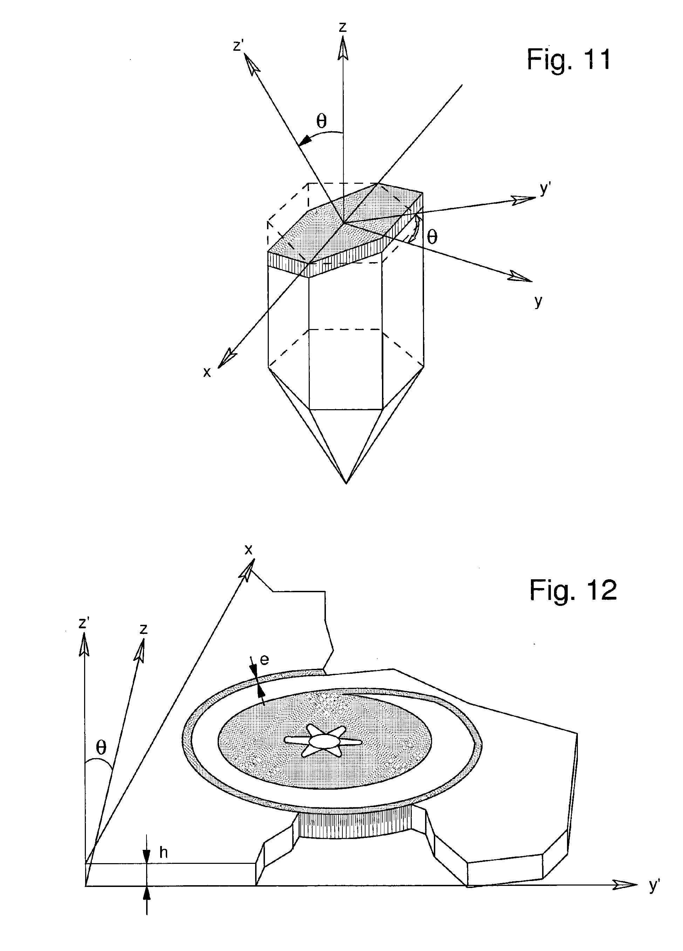

Les figures 11 et 12 montrent l'interprétation spatiale de l'axe z par rapport à un monocristal de quartz. Un cristal de quartz comporte des axes cristallographiques x, y, z. L'axe x est l'axe électrique et, l'axe y, l'axe mécanique. Selon l'exemple de la figure 11 et 12, la hauteur $h$ du spiral ou du diapason possède donc une orientation par rapport à l'axe cristallographique z suivant l'angle $\theta$ de coupe qui a été choisi.

Bien entendu, l'angle $\theta$ de coupe ne saurait se limiter à un angle unique par rapport à un axe, des rotations selon plusieurs angles par rapport à plusieurs axes sont également possibles pour obtenir l'effet technique désiré dans la présente invention. A titre d'exemple, l'angle $\theta$ de coupe finale pourrait ainsi être la résultante d'un premier angle $\Phi$ par rapport à l'axe x et d'un deuxième angle $\Theta$ par rapport à l'axe z.

A la figure 9, on s'aperçoit, comme illustré en trait continu, que le coefficient thermique du premier ordre $\alpha$ coupe l'axe nul autour d'un angle de coupe de 0 degré et de 12 degrés. On comprend donc que suivant l'angle de coupe du monocristal de quartz, il est possible d'obtenir « naturellement » un coefficient thermique du premier ordre $\alpha$ sensiblement nul, c'est-à-dire que le résonateur comporte une variation de fréquence au premier ordre quasiment indépendante de la température.

Ces caractéristiques avantageuses sont utilisées depuis plusieurs dizaines d'années pour former notamment des bases de temps pour des pièces d'horlogerie avec un angle de coupe proche de 0 degré.

A cette même figure 9, on s'aperçoit, comme illustré en traits interrompus, que le coefficient thermique du deuxième ordre $\beta$ ne coupe jamais l'axe nul. Dès lors, on comprend, même avec l'angle de coupe actuel proche de 0 degré, que le quartz reste sensible aux variations de température à cause de la variation du coefficient thermique au deuxième ordre $\beta$ mais dans une moindre mesure qu'avec le coefficient thermique du premier ordre $\alpha$.

Enfin à cette figure, on s'aperçoit que les angles de coupe négatifs dans le monocristal de quartz forment systématiquement un résonateur dont les coefficients thermiques sont négatifs aux premier $\alpha$ et deuxième ordres $\beta$.

Avantageusement, l'idée de l'invention est d'adapter un angle $\theta$ de coupe du quartz avec une couche unique de revêtement afin de compenser les coefficients thermiques de résonateurs à quartz aux premier $\alpha$ et deuxième $\beta$ ordres pour obtenir un résonateur très peu sensible aux variations de température.

A titre de définition, la variation relative de la fréquence d'un résonateur suit la relation suivante :

$$\frac{\Delta f}{f_0} = A + \alpha \cdot (T - T_0) + \beta \cdot (T - T_0)^2 + \gamma \cdot (T - T_0)^3$$

où :

- $\frac{\Delta f}{f_0}$ est la variation relative de fréquence, exprimée en ppm (10⁻⁶);

- *A* une constante qui dépend du point de référence, en ppm ;
- $T_0$ la température de référence, en °C;
- $\alpha$ le coefficient thermique du premier ordre, exprimé en ppm.°C$^{-1}$;
- $\beta$ le coefficient thermique du deuxième ordre, exprimé en ppm. °C$^{-2}$ ;
- $\gamma$ le coefficient thermique du troisième ordre, exprimé en ppm.°C$^{-3}$.

De plus, le coefficient thermoélastique (CTE) représente la variation relative du module d'Young en fonction de la température. Les termes « $\alpha$ » et « $\beta$ » qui sont utilisés ci-dessous représentent ainsi respectivement les coefficients thermiques du premier et du deuxième ordres c'est-à-dire la variation relative de la fréquence du résonateur en fonction de la température. Les termes «$\alpha$» et «$\beta$» dépendent du coefficient thermoélastique du corps du résonateur et des coefficients de dilatation du corps. De plus, les termes «$\alpha$» et «$\beta$» prennent également en compte les coefficients propres à une éventuelle inertie séparée, telle que, par exemple, le balancier pour un résonateur balancier - spiral.

Les oscillations de tout résonateur destiné à une base de temps ou de fréquence devant être entretenues, la dépendance thermique comprend également une contribution éventuelle du système d'entretien. Préférentiellement, le corps du résonateur est une âme de quartz recouverte d'un seul revêtement sur au moins une partie ou la totalité de sa surface extérieure et, éventuellement, par-dessus les métallisations habituelles nécessaires si un actionnement piézoélectrique est désiré. Bien évidemment, dans ce dernier cas, quel que soit le revêtement choisi, les plages de connexions doivent rester libres.

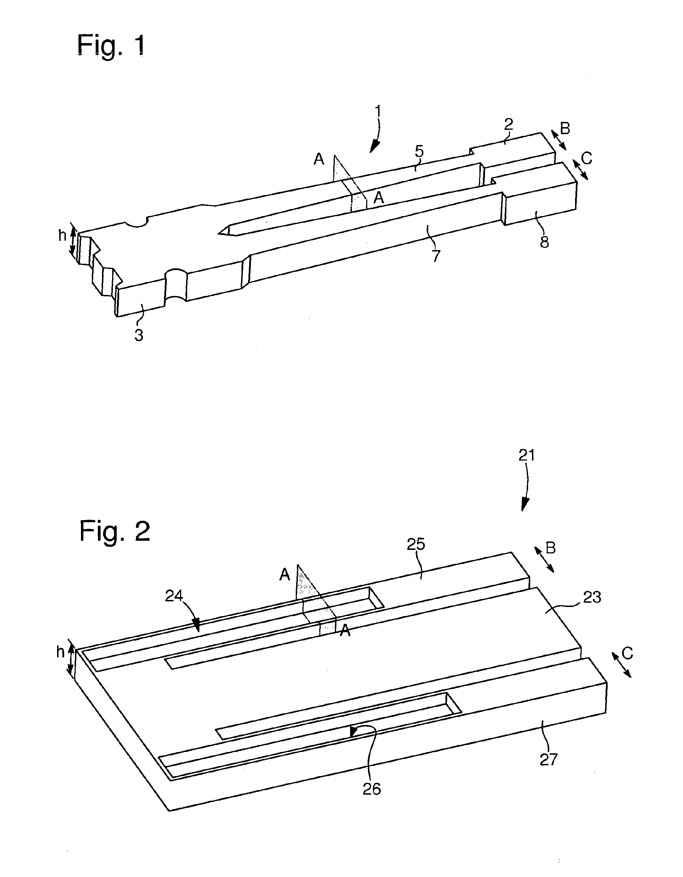

Dans l'exemple illustré aux figures 1 à 4, on peut voir des variantes de diapasons 1, 21, 31, 41 applicables à l'invention. Ils sont formés d'une base 3, 23, 33, 43 raccordée à deux bras 5, 7, 25, 27, 35, 37, 45, 47, lesquels sont destinés à osciller selon les directions respectives B et C.

Les variantes des figures 2 à 4 présentent des diapasons 21, 31, 41 du type inversé, c'est-à-dire que la base 23, 33, 43 se prolonge entre les deux bras 25, 27, 35, 37, 45, 47 afin d'optimiser le découplage entre la fixation et la zone active du résonateur 21, 31, 41 et d'optimiser la longueur des bras vibrants pour une surface donnée de matière. Les variantes des figures 2 à 4 présentent des diapasons 21, 31, 41 du type rainuré (également connu sous le nom anglais « groove »), c'est-à-dire que les deux bras 25, 27, 35, 37, 45, 47 comportent des rainures 24, 26, 34, 36, 44, 46 afin d'y déposer des électrodes pour augmenter le couplage piézoélectrique et permettre ainsi d'obtenir des résonateurs de petites tailles avec d'excellents paramètres électriques.

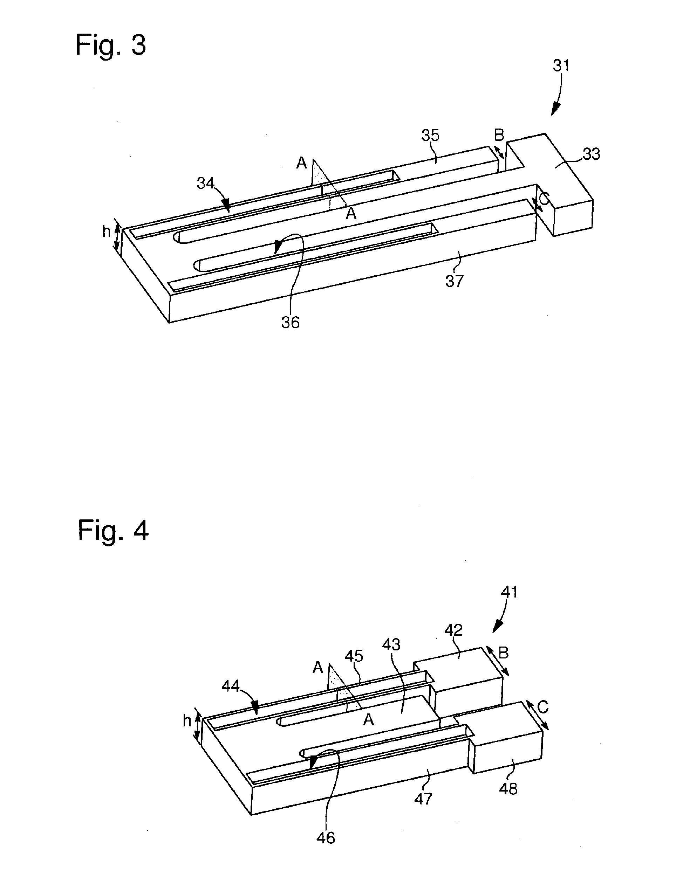

De plus, la figure 1 présente une variante de bras 5, 7 du type conique, c'est-à-dire dont la section diminue au fur et à mesure qu'on s'éloigne de la base 3 de façon à mieux répartir les contraintes élastiques sur la longueur des bras et ainsi augmenter le couplage des électrodes. Enfin, les figures 1 et 4 présentent des diapasons 1, 41 du type palmé, c'est-à-dire que les deux bras 5, 7, 45, 47 comportent à leur extrémité des palmes 2, 8, 42, 48 afin d'augmenter l'inertie d'oscillation des bras 5, 7, 45, 47 du résonateur 1, 41 pour permettre d'obtenir des résonateurs optimisés en longueur pour une fréquence donnée. On comprend donc qu'il existe une multitude de variantes possibles de diapasons qui peuvent, de manière non exhaustive, être du type inversé et/ou du type rainuré et/ou du type conique et/ou du type palmé.

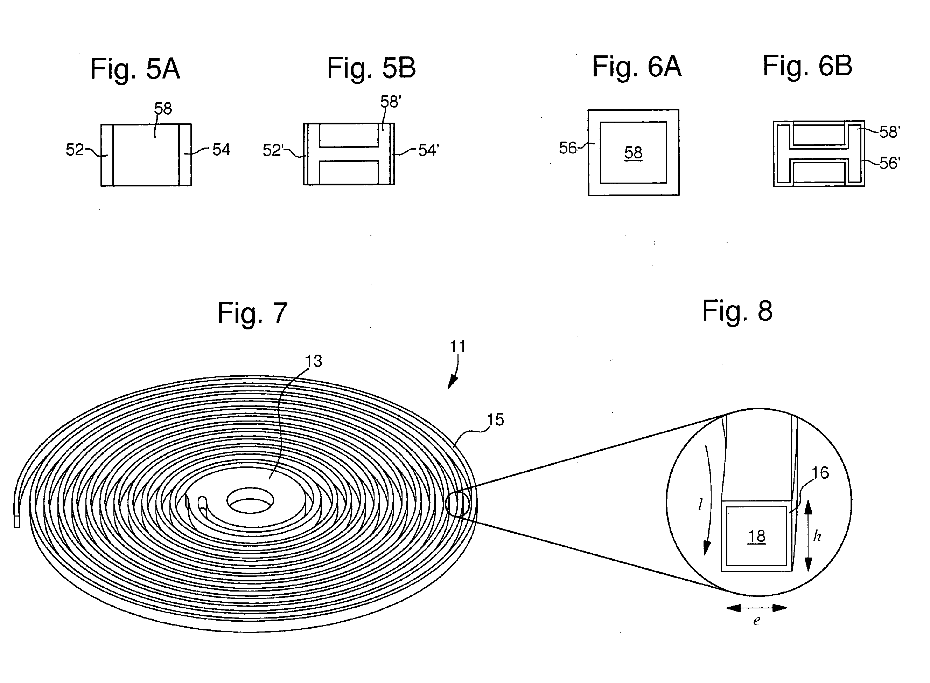

Avantageusement selon l'invention, chaque diapason 1, 21, 31, 41 comporte des coefficients thermiques des premier $\alpha$ et deuxième $\beta$ ordres qui sont compensés par dépôt d'une couche 52, 54, 56, 52', 54', 56' contre l'âme 58, 58' du diapason 1, 21, 31, 41. Les figures 5A, 5B, 6A et 6B proposent quatre exemples non exhaustifs de coupe du corps des diapasons 1, 21, 31, 41 selon le plan A-A permettant de mieux voir leur section en forme de quadrilatère ou de H au moins partiellement recouverte d'une couche 52, 54, 56, 52', 54', 56'. Bien évidemment, les revêtements 52, 54, 56, 52', 54', 56' ne sont pas à l'échelle par rapport aux dimensions de l'âme 58, 58', ceci afin de mieux montrer les localisations de chaque partie 52, 54, 56, 52', 54', 56'.

L'étude a été effectuée dans un premier temps pour un résonateur diapason 1 coupé dans un monocristal de quartz selon des angles négatifs par rapport à l'axe z c'est-à-dire selon des coefficients thermiques aux premier $\alpha$ et deuxième $\beta$ ordres qui sont négatifs. Des matériaux dont les coefficients thermoélastiques aux premier et deuxième ordres CTE1, CTE2 sont positifs ont donc été recherchés. Il a été trouvé que l'oxyde de germanium (GeO$_2$), l'oxyde de tantale (Ta$_2$O$_{5)}$ et des oxydes de zirconium ou d'hafnium stabilisés répondent à ces caractéristiques.

Des analyses ont été effectuées pour trouver un angle $\theta$ de coupe dans le quartz avec une couche unique de revêtement afin de compenser les coefficients thermiques de résonateurs à quartz aux premier $\alpha$ et deuxième $\beta$ ordres. Pour le cas de la figure 5A, c'est-à-dire un revêtement 52, 54 sur chaque flanc de bras 5, 7 du diapason 1, il a été trouvé une convergence des coefficients thermiques des premier $\alpha$ et deuxième $\beta$ ordres du résonateur diapason 1 pour un angle $\theta$ de -8,408 degrés par rapport à l'axe z et une épaisseur d de 5,47 $\mu$m pour chaque couche 2, 4.

Cette convergence est illustrée à la figure 10 où on voit que bien que les premier $\alpha$ et deuxième $\beta$ coefficients thermiques du diapason 1 coupent tous les deux l'axe nul pour une même épaisseur *d* des couches 2, 4.

Pour le cas de la figure 6A, c'est-à-dire un revêtement 56 en recouvrement total des bras 5, 7 du diapason 1, il a été trouvé une convergence des coefficients thermiques des premier $\alpha$ et deuxième $\beta$ ordres du résonateur diapason 1 pour un angle $\theta$ de -8,416 degrés par rapport à l'axe z et une épaisseur *d* de 4,26 $\mu$m pour la couche 6. On en conclu donc que l'angle $\theta$ de coupe est sensiblement équivalent par rapport à la variante de la figure 5A, par contre l'épaisseur $d$ de revêtement 56 nécessaire est bien plus faible.

Selon une interprétation similaire pour des sections de diapasons du type rainuré illustré aux figures 5B et 6B, un angle $\theta$ et une épaisseur $d$ peuvent également être déterminées. Le cas de la figure 6B est particulièrement avantageux en ce que le revêtement 56' au niveau des arêtes des rainures permet l'augmentation de la surface sur laquelle la couche de compensation est active. On comprend donc, pour le cas particulier de la figure 6B, que l'épaisseur $d$ de revêtement 56' sera nécessairement encore moins grande.

Il est à noter pour toutes variantes ci-dessus que si les bras 5, 7, 25, 27, 35, 37, 45, 47 sont nécessairement revêtus, la base 3, 23, 33, 43 n'a pas nécessairement à l'être. En effet, ce sont aux niveaux des zones de contraintes que le revêtement 52, 54, 56, 52', 54', 56' doit être présent.

Dans l'exemple illustré aux figures 7 et 8, on peut voir un spiral 11 dont le corps 15 est venu de forme avec sa virole 13 et dont les coefficients thermiques des premier $\alpha$ et deuxième $\beta$ ordres du corps sont compensés. La figure 8 propose une coupe du corps 15 du spiral 11 permettant de mieux voir sa section en forme de quadrilatère. Le corps 15 peut ainsi être défini par sa longueur $l$, sa hauteur $h$ et son épaisseur $e$. La figure 8 montre un exemple où l'âme 18 est entièrement revêtue de manière similaire à la figure 6A. Bien évidemment, la figure 8 présente uniquement un exemple non limitatif et, comme pour les diapasons 1, 21, 31, 41, le spiral 11 peut comporter un revêtement sur au moins une partie ou la totalité de la surface extérieure du corps 15.

L'étude a donc été effectuée dans un deuxième temps pour un résonateur du type balancier - spiral dont le spiral 11 est coupé dans un monocristal de quartz selon des coefficients thermiques aux premier $\alpha$ et deuxième $\beta$ ordres qui sont négatifs et avec des matériaux en recouvrement dont les coefficients thermoélastiques aux premier et deuxième ordres CTE1, CTE2 sont positifs.

Des analyses ont été effectuées pour trouver un angle $\theta$ de coupe dans le quartz avec une couche unique de revêtement afin de compenser les coefficients thermiques de résonateurs à quartz aux premier $\alpha$ et deuxième $\beta$ ordres.

Pour le cas de la figure 8, c'est-à-dire un revêtement 16 en recouvrement total du corps 15 du spiral 11, il a été trouvé une convergence des coefficients thermiques des premier $\alpha$ et deuxième $\beta$ ordres du résonateur pour plusieurs valeurs de dilatation du balancier :

| $\alpha_{bal}$ | $\theta$ | $d$ |
|---|---|---|
| 5 | -15,9 | 8,5 |
| 10 | -12,3 | 7,2 |
| 15 | -8,0 | 6,1 |
| 20 | -2,4 | 5,5 |

où :

- $\alpha_{bal}$ est le coefficient de dilatation du balancier, exprimé en ppm.°C$^{-1}$ ;
- $\theta$ est l'angle de coupe dans le quartz, exprimé en degrés ;
- $d$ est l'épaisseur du revêtement de GeO$_2$, exprimé en $\mu$m.

Par conséquent, au vu des explications ci-dessus, l'enseignement de l'invention ne saurait se limiter à un matériau de revêtement particulier, ni même à un résonateur particulier ou même à une zone de dépôt particulière du revêtement. L'exemple de la coupe par rapport à l'axe z du cristal de quartz n'est pas non plus limitatif. D'autres références dans le cristal de quartz comme les axes x et y sont également possibles tout comme plusieurs rotations sont possibles comme expliqué ci-dessus.

On comprend donc qu'il est possible de manière avantageuse selon l'invention de compenser les coefficients thermiques des premier $\alpha$ et deuxième $\beta$ ordres de n'importe quel résonateur à quartz avec une couche unique dont les coefficients thermoélastiques aux premier et deuxième ordres CTE1, CTE2 sont de signes opposés à ceux $\alpha$ et $\beta$ Il faut donc comprendre qu'il est également possible de compenser les coupes alternatives $\theta'$ dans un monocristal de quartz dont les coefficients thermiques aux premier $\alpha$ et deuxième $\beta$ ordres ne sont pas négatifs.

A titre d'exemple non limitatif, si des coefficients thermiques alternatifs aux premier $\alpha'$ et deuxième $\beta'$ ordres sont respectivement positif et négatif, un revêtement alternatif dont les coefficients thermoélastiques aux premier et deuxième ordres CTE1', CTE2' sont de signes opposés, c'est-à-dire respectivement négatif et positif, peut être utilisé. Un tel revêtement peut ainsi être formé à partir de diamant synthétique qui autorise avantageusement de laisser le résonateur transparent.

**Revendications**

**1.** Résonateur thermocompensé comportant un corps utilisé en déformation, l'âme (58, 58', 18) du corps (3, 5, 7, 15, 23, 25, 27, 33, 35, 37, 43, 45, 47) étant formé à partir d'une plaque formée selon un angle (θ, θ') de coupe dans un cristal de quartz déterminant des coefficients thermiques aux premier et deuxième ordres (α, β, α', β') de la variation relative de la fréquence **caractérisé en ce que** le corps (3, 5, 7, 15, 23, 25, 27, 33, 35, 37, 43, 45, 47) comporte un revêtement (52, 54, 56, 52', 54', 56', 16) déposé au moins partiellement contre l'âme (58, 58', 18) et ayant des variations du module d'Young en fonction de la température aux premier et deuxième ordres (CTE1, CTE2, CTE1', CTE2') de signes opposés respectivement auxdits premier et deuxième ordres (α, β, α', β') des coefficients thermiques de la variation relative de la fréquence dudit résonateur afin de rendre ces derniers sensiblement nuls.

**2.** Résonateur la revendication 1, **caractérisé en ce que** le corps (3, 5, 7, 15) comporte une section sensiblement en forme d'un quadrilatère dont les faces sont identiques deux à deux.

**3.** Résonateur selon la revendication 1, **caractérisé en ce que** le corps (3, 5, 7, 15) comporte une section sensiblement en forme d'un quadrilatère dont les faces sont entièrement revêtues.

**4.** Résonateur selon l'une des revendications précédentes, **caractérisé en ce que** l'angle (θ) de coupe de la plaque est choisi afin que lesdits coefficients thermiques aux premier et deuxième ordres (α, β) de la variation relative de la fréquence soient négatifs.

**5.** Résonateur selon la revendication précédente, **caractérisé en ce que** le revêtement (52, 54, 56, 16, 52', 54', 56') comporte des variations du module d'Young aux premier et deuxième ordres (CTE1, CTE2) qui sont positifs.

**6.** Résonateur selon la revendication précédente, **caractérisé en ce que** le revêtement (52, 54, 56, 52', 54', 56', 16) comporte de l'oxyde de germanium.

**7.** Résonateur selon la revendication 5, **caractérisé en ce que** le revêtement (52, 54, 56, 52', 54', 56', 16) comporte de l'oxyde de tantale.

**8.** Résonateur selon l'une des revendications 1 à 3, **caractérisé en ce que** l'angle (θ) de coupe de la plaque est choisi afin que lesdits coefficients thermiques aux premier et deuxième ordres (α', β') de la variation relative de la fréquence soient respectivement positif et négatif.

**9.** Résonateur selon la revendication précédente, **caractérisé en ce que** le revêtement (52, 54, 56, 52', 54', 56', 16) comporte des variations du module d'Young aux premier et deuxième ordres (CTE1', CTE2') respectivement négatif et positif.

**10.** Résonateur selon la revendication précédente, **caractérisé en ce que** le revêtement (52, 54, 56, 52', 54', 56', 16) comporte du diamant synthétique.

**11.** Résonateur selon l'une des revendications précédentes, **caractérisé en ce que** le corps (15) est un barreau enroulé sur lui-même en formant un spiral (11) et est couplé avec une inertie.

**12.** Résonateur selon l'une des revendications 1 à 10, **caractérisé en ce que** le corps comporte au moins deux bras (5, 7, 25, 27, 35, 37, 45, 47) montés symétriquement afin de former un diapason (1, 21, 31, 41).

**13.** Résonateur selon la revendication précédente, **caractérisé en ce que** le diapason (1, 21, 31, 41) est du type inversé et/ou du type rainuré et/ou du type conique et/ou du type palmé.

**14.** Résonateur selon l'une des revendications 1 à 10, **caractérisé en ce que** le corps est un MEMS.

**15.** Pièce d'horlogerie **caractérisée en ce qu'**elle comporte au moins un résonateur conforme à l'une des revendications précédentes.

**Patentansprüche**

1. Thermisch kompensierter Resonator, der einen Körper umfasst, der verformt verwendet wird, wobei der Kern (58, 58', 18) des Körpers (3, 5, 7, 15, 23, 25, 27, 33, 35, 37, 43, 45, 47) aus einer Platte gebildet ist, die längs eines Schnittwinkels ($\theta$, $\theta'$) in einem Quarzkristall geformt ist, der die thermischen Koeffizienten erster und zweiter Ordnung ($\alpha$, $\beta$, $\alpha'$, $\beta'$) der relativen Änderung der Frequenz bestimmt, **dadurch gekennzeichnet, dass** der Körper (3, 5, 7, 15, 23, 25, 27, 33, 35, 37, 43, 45, 47) eine Beschichtung (52, 54, 56, 52', 54', 56', 16) aufweist, die wenigstens teilweise auf dem Kern (58, 58', 18) abgelagert ist und Veränderungen des Young-Moduls als Funktion der Temperatur erster und zweiter Ordnung (CTE1, CTE2, CTE1', CTE2') mit Vorzeichen, die zu der ersten bzw. zweiten Ordnung ($\alpha$, $\beta$, $\alpha'$, $\beta'$) der thermischen Koeffizienten der relativen Veränderung der Frequenz des Resonators entgegengesetzt sind, besitzt, um diese Letzteren im Wesentlichen gleich null zu machen.

2. Resonator nach Anspruch 1, **dadurch gekennzeichnet, dass** der Körper (3, 5, 7, 15) einen Querschnitt im Wesentlichen in Form eines Vierecks, dessen Flächen paarweise gleich sind, besitzt.

3. Resonator nach Anspruch 1, **dadurch gekennzeichnet, dass** der Körper (3, 5, 7, 15) einen Querschnitt im Wesentlichen in Form eines Vierecks, dessen Flächen vollständig beschichtet sind, besitzt.

4. Resonator nach einem der vorhergehenden Ansprüche, **dadurch gekennzeichnet, dass** der Schnittwinkel ($\theta$) der Platte in der Weise gewählt ist, dass die thermischen Koeffizienten erster und zweiter Ordnung ($\alpha$, $\beta$) der relativen Veränderung der Frequenz negativ sind.

5. Resonator nach dem vorhergehenden Anspruch, **dadurch gekennzeichnet, dass** die Beschichtung (52, 54, 56, 16, 52', 54', 56') Veränderungen des Young-Moduls erster und zweiter Ordnung (CTE1, CTE2) aufweist, die positiv sind.

6. Resonator nach dem vorhergehenden Anspruch, **dadurch gekennzeichnet, dass** die Beschichtung (52, 54, 56, 52', 54', 56', 16) Germaniumoxid enthält.

7. Resonator nach Anspruch 5, **dadurch gekennzeichnet, dass** die Beschichtung (52, 54, 56, 52', 54', 56', 16) Tantaloxid enthält.

8. Resonator nach einem der Ansprüche 1 bis 3, **dadurch gekennzeichnet, dass** der Schnittwinkel ($\theta$) der Platte in der Weise gewählt ist, dass die thermischen Koeffizienten erster und zweiter Ordnung ($\alpha'$, $\beta'$) der relativen Veränderung der Frequenz positiv bzw. negativ sind.

9. Resonator nach dem vorhergehenden Anspruch, **dadurch gekennzeichnet, dass** die Beschichtung (52, 54, 56, 52', 54', 56', 16) Veränderungen des Young-Moduls erster und zweiter Ordnung (CTE1', CTE2') aufweist, die negativ bzw. positiv sind.

10. Resonator nach dem vorhergehenden Anspruch, **dadurch gekennzeichnet, dass** die Beschichtung (52, 54, 56, 52', 54', 56', 16) künstlichen Diamant enthält.

11. Resonator nach einem der vorhergehenden Ansprüche, **dadurch gekennzeichnet, dass** der Körper (15) ein Stab ist, der auf sich selbst gebogen ist und dabei eine Spirale (11) bildet und mit einer Trägheit gekoppelt ist.

12. Resonator nach einem der Ansprüche 1 bis 10, **dadurch gekennzeichnet, dass** der Körper wenigstens zwei Arme (5, 7, 25, 27, 35, 37, 45, 47) aufweist, die symmetrisch montiert sind, um eine Stimmgabel (1, 21, 31, 41) zu bilden.

13. Resonator nach dem vorhergehenden Anspruch, **dadurch gekennzeichnet, dass** die Stimmgabel (1, 21, 31, 41) vom inversen Typ und/oder vom gerillten Typ und/oder vom konischen Typ und/oder vom abgeflachten Typ ist.

14. Resonator nach einem der Ansprüche 1 bis 10, **dadurch gekennzeichnet, dass** der Körper ein MEMS ist.

15. Zeitmessgerät, **dadurch gekennzeichnet, dass** es wenigstens einen Resonator nach einem der vorhergehenden Ansprüche enthält.

**Claims**

1. Temperature-compensated resonator including a body used in deformation, wherein the core (58, 58', 18) of the body (3, 5, 7, 15, 23, 25, 27, 33, 35, 37, 43, 45, 47) is formed from a plate formed at a cut angle (θ, θ') in a quartz crystal determining first and second orders temperature coefficients (α, β, α', β'), of the relative frequency variation **characterized in that** the body (3, 5, 7, 15, 23, 25, 27, 33, 35, 37, 43, 45, 47) includes a coating (52, 54, 56, 52', 54', 56', 16) deposited at least partially on the core (58, 58', 18) and having first and second orders Young's modulus variations according to temperature (CTE1, CTE2, CTE1', CTE2') of opposite signs respectively to said first and second orders (α, β, α', β') temperature coefficients of the relative frequency variation of said resonator in order to render the latter substantially zero.

2. Resonator according to claim 1, **characterized in that** the body (3, 5, 7, 15) has a substantially quadrilateral-shaped section with faces in identical pairs.

3. Resonator according to claim 1, **characterized in that** the body (3, 5, 7, 15) includes a substantially quadrilateral-shaped section whose faces are entirely coated.

4. Resonator according to any of the preceding claims, **characterized in that** the cut angle (θ) of the plate is selected such that said first and second orders temperature coefficients (α, β) of the relative frequency variation are negative.

5. Resonator according to the preceding claim, **characterized in that** the coating (52, 54, 56, 16, 52', 54', 56') has first and second orders Young's modulus variations (CTE1, CTE2) which are positive.

6. Resonator according to the preceding claim, **characterized in that** the coating (52, 54, 56, 52', 54', 56', 16) includes germanium oxide.

7. Resonator according to claim 5, **characterized in that** the coating (52, 54, 56, 52', 54', 56', 16) includes tantalum oxide.

8. Resonator according to any of claims 1 to 3, **characterized in that** the cut angle (θ') of the plate is selected such that said first and second orders temperature coefficients (α', β') of the relative frequency variation are respectively positive and negative.

9. Resonator according to the preceding claim, **characterized in that** the coating (52, 54, 56, 52', 54', 56', 16) includes first and second orders Young's modulus variations (CTE1', CTE2') which are respectively negative and positive.

10. Resonator according to the preceding claim, **characterized in that** the coating (52, 54, 56, 52', 54', 56', 16) includes synthetic diamond.

11. Resonator according to any of the preceding claims, **characterized in that** the body (15) is a bar wound around itself to form a balance spring (11) and is coupled with an inertia member.

12. Resonator according to any of claims 1 to 10, **characterized in that** the body includes at least two symmetrically mounted arms (5, 7, 25, 27, 35, 37, 45, 47) forming a tuning fork (1, 21, 31, 41).

13. Resonator according to the preceding claim, **characterized in that** the tuning fork (1, 21, 31, 41) is of the inverted and/or grooved and/or conical and or flipper type.

14. Resonator according to any of claims 1 to 10, **characterized in that** the body is a MEMS.

15. Timepiece **characterized in that** it includes at least one resonator according to any of the preceding claims.

## Fig. 1

## Fig. 2

Fig. 3

Fig. 4

## Fig. 5A

52 — 58 — 54

## Fig. 5B

52' — 58' — 54'

## Fig. 6A

56 — 58

## Fig. 6B

58'
56'

## Fig. 7

13

11

15

## Fig. 8

$l$

16

18

$h$

$e$

# Fig. 9

# Fig. 10

Fig. 11

Fig. 12

**EP 2 395 662 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1422436 A
- WO 2008043727 A
- US 2005184628 A